# EUROPÄISCHE PATENTSCHRIFT

(11) **EP 2 166 128 B1**
(45) Veröffentlichungstag und Bekanntmachung des Hinweises auf die Patenterteilung: **09.11.2011**
(21) Anmeldenummer: 08016572.3
(22) Anmeldetag: 19.09.2008
(51) Int. Cl.: C23C 14/34

(54) **Verfahren zum Herstellen von Metalloxidschichten durch Funkenverdampfung**
Method for producing metal oxide coatings by means of spark nebulisation
Procédé de fabrication de couches d'oxyde de métal par évaporation par étincelles

(43) Veröffentlichungstag der Anmeldung: 24.03.2010
(73) Patentinhaber: Oerlikon Trading AG, Trübbach, 9477 Trübbach (CH)
(72) Erfinder: Ramm, Jürgen, Dr., 7304 Maienfeld (CH); Widrig, Beno, 7310 Bad Ragaz (CH)
(74) Vertreter: nospat Patent- und Rechtsanwälte Naefe Oberdorfer Schmidt

(56) Entgegenhaltungen:
- EP-A- 1 391 533
- EP-A- 1 700 928
- WO-A-2008/009619
- WO-A1-2009/129879
- WO-A1-2009/129880
- DE-A1- 19 522 331
- US-A1- 2004 121 147
- US-A1- 2005 214 579

## Beschreibung

Die Erfindung betrifft ein Verfahren zum Herstellen von Metalloxidschichten durch Funkenverdampfung nach dem Oberbegriff des Anspruchs 1.

Insbesondere betrifft die Erfindung die Herstellung, Auswahl und den Betrieb sogenannter "Legierungstargets", d.h. Targets, die aus mindestens zwei metallischen und/oder halbmetallischen Komponenten bestehen und die als Verdampfungsquellen bei der kathodischen Funkenverdampfung dienen.

Von besonderer Bedeutung ist die Erfindung für "Legierungstargets", die aus Metallen mit sehr unterschiedlichen Schmelztemperaturen zusammengesetzt sind. Ganz besonders trifft dies deshalb auf Targets zu, die Aluminium als den niederschmelzenden metallischen Bestandteil aufweisen.

Diese Legierungstargets werden definiert als mindestens zwei metallische Komponenten umfassend, die aber auch als intermetallische Verbindungen und/oder Mischkristalle vorliegen können.

Ein pulvermetallurgisches Target ist hierbei ein Target, das aus Pulver von Metallen, Halbmetallen, intermetallischen Verbindungen, Mischkristallen hergestellt wird und bei dem man nach dem Herstellungsprozess (beispielsweise einem heißisostatischen Press-Prozess) noch die Körner des Pulvers im Mikroskop auflösen kann. Ein pulvermetallurgisches Legierungstarget kann somit aus einer Mischung aus Pulvern von Metallen und/oder Halbmetallen, einem Pulver aus einer intermetallischen Verbindung oder einer Mischung aus Pulvern von Metallen und/oder Halbmetallen und oder intermetallischen Verbindungen hergestellt sein. Im Gegensatz hierzu ist ein schmelzmetallurgisches Legierungstarget ein Target, bei dem die Ausgangsmetalle bzw. Halbmetalle eine intermetallische Phase bilden. Charakteristisch hierfür ist, dass im Mikroskop die Körner des Ausgangsmaterials nicht mehr aufgelöst werden können, d.h. nicht mehr vorliegen.

Zudem gibt es sogenannte plasmagespritzte Targets. Dies sind Targets, die durch Plasmaspritzen hergestellt worden sind. Bei diesen Targets kann es zu einer teilweisen oder vollständigen Bildung von intermetallischen Komponenten der Ausgangsmaterialien kommen. Allgemein kann aber das plasmagespritzte Target sowohl Körner als auch intermetallische Phasen enthalten.

Die kathodische Funkenverdampfung ist ein seit Jahren etabliertes Verfahren, das zur Beschichtung von Werkzeugen und Bauteilen Anwendung findet und mit dem sowohl metallische Schichten in breiter Vielfalt als auch Metallnitride und Metallcarbonitride abgeschieden werden. Bei all diesen Anwendungen sind die Targets Kathode einer Funkenentladung, die bei niedrigen Spannungen und hohen Strömen betrieben wird und mit der das Target(Kathoden)material verdampft wird. Als einfachste und billigste Stromversorgungen zum Betreiben der Funkenentladungen werden Gleichspannungsstromversorgungen benutzt.

Problematischer ist die Herstellung von Metalloxiden mittels Funkenverdampfung. Es ist schwierig, eine Gleichstromfunkenentladung in Sauerstoff bzw. sauerstoffhaltiger Atmosphäre zu betreiben, um oxidische Schichten etwa auf Werkzeugen oder Bauteilen abzuscheiden. Es besteht dann die Gefahr, dass sich die beiden Elektroden der Gleichstromentladungen (einerseits das Target als Kathode sowie andrerseits die Anode, die oft auf Massepotential betrieben wird) mit isolierenden Schichten belegen. Das führt auf dem Target (Kathode) dazu, dass sich je nach Quellendesign (Magnetfeld, Ort und Art des Gaseinlasses) der elektrisch leitende Bereich, in dem der Funken läuft, einschnürt und es schließlich zu einem Unterbruch der Funkenentladung kommt.

Aus der DE 195 22 331 A1 ist ein Verfahren zum Beschichten mindestens eines Werkstückes, eine Anlage hierfür sowie ein Verfahren zum Betrieb einer kathodischen Bogenentladung und Verwendung derselben bekannt. Um mittels kathodischen Bogenverdampfens Werkstücke mit einem Oxid oder einer Metalllegierung zu beschichten wird ein Target (2, 3) in einer Sauerstoffatmosphäre kathodisch bogend verdampft, wobei das Target in einer einzigen kristallografischen Phase vorliegt. Hierbei soll die Bogenentladung in einem Sauerstoff-Partialdruckbereich und/oder einem Bereich der angelegten Magnetfeldstärke (B) betrieben werden, in welchem eine Mehrzahl von Kathodenpunkten brennen, wodurch Spritzerbildung unterbunden werden soll. Das Target soll hierbei aus einer Metalllegierung ausgebildet werden, wobei die Legierung im Target im Wesentlichen in einer einzigen Phase vorliegt, wobei es gegossen oder eine intermetallische Legierungsverbindung pulverisiert und das Target thermomechanisch geformt wird. Die Legierung kann hierbei insbesondere eine Legierung sein, die mindestens 5 % Chrom, vorzugsweise 10 % bis 50 % Chrom umfasst, wobei die Legierung insgesamt eine Aluminium-Chrom-Legierung ist.

In T.D. Schemmel, R.L. Cunningham, and H. Randhawa, Thin Solid Films 181 (1989) 597, wird ein Hochratebeschichtungsprozess für Al₂O₃ beschrieben. Der Sauerstoffgaseinlass wurde nach der Filterung des Funkens in der Substratnähe eingelassen. Es wird erwähnt, dass der Einlass des Sauerstoffs nach dem Filter in der Nähe des Substrates wichtig ist, um die Oxidation des Targets zu reduzieren und die Funkenentladung zu stabilisieren.

In der US 5 518 597 wird ebenfalls die Herstellung oxidischer Schichten beschrieben. Die Schrift beinhaltet die Schichtabscheidung bei erhöhten Temperaturen und beruht darauf, dass auch die Anode geheizt (800°C - 1200°C) und das Reaktivgas nicht direkt beim Target eingelassen wird. Die hohe Anodentemperatur hält die Anode leitend und ermöglicht einen stabilen Betrieb der Funkenentladung.

In US 2007/0000772 A1, WO 2006/099760 A2 und WO 2008/009619 A1 wird ausführlich das Betreiben einer Funkenentladung in Sauerstoffatmosphäre beschrieben und auf die Methoden eingegangen, unter denen ein vollständiges Belegen mit einer für Gleichstrom (DC) undurchlässigen Isolationsschicht auf der Kathode vermieden werden kann.

US 2007/0000772 A1 und WO 2006/099760 A2 beschreiben vor allem das Betreiben der Funkenquelle mit gepulstem Strom als einen wesentlichen Faktor, die Kathodenfläche frei von undurchlässigen Oxidschichten zu halten und eine stabile Funkenentladung zu gewährleisten. Durch das Pulsen des Funkenstroms, zu dem spezielle Stromversorgungen notwendig sind, wird der Funken ständig auf neue Bahnen über das Target gelenkt und verhindert, dass er sich lediglich in bevorzugten Bereichen bewegt und die übrigen Targetbereiche sich mit dickem Oxid belegen (wie das beim "steered arc" (geführter Funke) der Fall ist).

In WO 2008/009619 A1 wird das Betreiben der Funkenentladung in Sauerstoffatmosphäre beschrieben, wobei die Kathode mit einem bevorzugt kleinen und zur Targetoberfläche senkrecht stehenden Magnetfeld versehen ist. Dieses ermöglicht einen über die Targetoberfläche regelmäßigen Funkenverlauf und verhindert damit ebenfalls eine für den Gleichstrom undurchlässig dicke Aufoxidation des Targets.

Auf der Basis dieser drei Schriften des Standes der Technik ist es möglich, eine stabile Funkenentladung über mehrere Stunden in reiner Sauerstoffatmosphäre zu gewährleisten. Diese Verfahren arbeiten stabil und reproduzierbar für elementare Targets und für schmelzmetallurgisch hergestellte Targets.

Die zunehmende Nutzung der Funkenverdampfung zur Herstellung unterschiedlichster Metalloxide erfordert eine flexible und kostengünstige Targetproduktion. Viele Targets werden in einem dem Fachmann bestens bekannten Verfahren mittels heiß isostatischen Pressen (HIP) hergestellt. Falls man beispielsweise ein Al-Cr-Target fertigen möchte, wird ein Pulver oder Pulvergemisch gewünschter Zusammensetzung aus den Elementen (hier beispielhaft und ohne Einschränkung: Al und Cr) in einem Behälter eingeschlossen, der in Vakuum hohen Temperaturen ausgesetzt wird, um Luft und Feuchtigkeit im Pulver zu reduzieren. Der Container wird anschließend verschlossen und bei hoher Temperatur hohem Druck ausgesetzt. Dieses Verfahren reduziert die inneren Hohlräume und schafft eine gewisse Bindung des Pulvers. Das resultierende Material besitzt eine uniforme Verteilung bezüglich der Korngröße und annähernd 100 % Dichte.

Aufgabe der Erfindung ist es, ein Verfahren zum Herstellen von Metalloxidschichten durch Funkenverdampfen zu schaffen, mit welchem Metalloxidschichten zuverlässig abgeschieden werden und welches möglichst kostengünstig durchführbar ist.

Die Aufgabe wird mit einem Verfahren mit den Merkmalen des Anspruch 1 gelöst.

Vorteilhafte Weiterbildungen sind in den hiervon abhängigen Unteransprüchen gekennzeichnet.

Eine weitere Aufgabe ist es, ein Target für die Herstellung von Metalloxidschichten zu schaffen, mit welchen Metalloxidschichten zuverlässig, ohne Einschlüsse oder vorzeitigem Verschleiß des Targets abgeschieden werden können und welches kostengünstig herstellbar ist.

Die Aufgabe wird mit einem Target mit den Merkmalen des Anspruchs 5 gelöst.

Vorteilhafte Weiterbildungen sind in den hiervon abhängigen Ansprüchen gekennzeichnet.

Eine weitere Aufgabe ist es, Metalloxidschichten zu schaffen, die bei beliebiger Zusammensetzung kostengünstig und zuverlässig abgeschieden werden können.

Das erfindungsgemäße Verfahren sieht es vor, oxidische Schichten mittels PVD unter Benutzung eines Targets zu erzeugen, wobei das Target aus zumindest zwei metallischen oder halbmetallischen Bestandteilen besteht, welche später die Metalle oder Halbmetalle der Metall- oder Halbmetalloxidschicht ausbilden sollen, wobei die Zusammensetzung des Targets so gewählt ist, dass beim Aufheizen im Übergang von der Raumtemperatur in die Flüssigphase bei dieser Zusammensetzung keine Phasengrenzen rein fester Phasen bezogen auf das Phasendiagramm der (erschmolzenen) Mischung der Bestandteile überschritten werden. Bei dieser Betrachtung wird somit theoretisierend das heterogen vorliegende pulvermetallurgische Target wie ein quasi erschmolzenes Target angesehen.

Da man bei der Anwendung dieses PVD-Verfahrens, insbesondere mit pulvermetallurgisch hergestellten Targets aber nicht auf die Metalloxidzusammensetzungen festgelegt sein will, die durch die obige Targetzusammensetzung bestimmt wird, bei der im Phasendiagramm lediglich von einer festen Phase direkt die flüssige Phase erreicht wird, ohne zusätzliche Phasengrenzen zu weiteren rein festen Phasen zu überschreiten, kann man erfindungsgemäß jede gewünschte Metalloxidzusammensetzung dadurch herstellen, dass man zunächst die Zusammensetzungen der metallischen und halbmetallischen Bestandteile auswählt, bei denen keine Phasengrenzen rein fester Phasen überschritten werden, aus diesen dann erste Komponenten herstellt und anschließend aus diesen ersten Komponenten und gegebenenfalls den reinen Metallen, ein Targetgemisch mit jeder gewünschten Endzusammensetzung herstellt.

Hat man beispielsweise zwei Metalle A und B vorliegen, und wünscht, dass diese beiden Metalle im entstehenden Metalloxid in gleichen Anteilen vorliegt, wird im Phasendiagramm zunächst ermittelt, ob bei einer Konzentration von jeweils 50 % der Metalle die erschmolzene Mischung der Metalle ohne den Übergang in eine weitere feste Phase bei höheren Temperaturen direkt in die flüssige Phase übergeht. Ist dies der Fall, kann hieraus ein pulvermetallurgisches Target mit gleichen Anteilen der Metalle A und B erstellt werden, ohne die von den Erfindern aufgefundenen Nachteile in Kauf nehmen zu müssen.

Wird bei diesen Metallen A und B ein solcher Zustand, bei dem die Mischung aus beiden Metallen ohne eine weitere feste Phase in die flüssige Phase übergeht, nur bei A:B = 75:25 und A:B = 25:75 gefunden, wird zunächst eine erste Komponente X mit einer Zusammensetzung von 75 A und 25 B in Formeiner intermetallischen Verbindung hergestellt und sodann die zweite Komponente Y mit A:B = 25:75 ebenfalls in Form einer intermetallischen Verbindung hergestellt. Anschließend werden diese beiden Komponenten X und Y zerkleinert, so dass Pulver entsteht. Eine der Komponenten X oder Y kann anstelle einer intermetallischen Verbindung auch ein reines Metall oder Halbmetall sein.

Sodann wird pulvermetallurgisch aus den Komponenten X und Y ein pulvermetallurgisches Target hergestellt, wobei die Komponenten X und Y zu gleichen Anteilen enthalten sind. Hierdurch wird dann die entsprechende Verteilung A:B = 50:50 erzielt, ohne jedoch beim Durchführen des PVD-Verfahrens und insbesondere des kathodischen Funkenverdampfungsverfahrens Komponenten zu verdampfen, bei deren Erhitzen eine zweite feste Phase durchlaufen würde.

Die Erfindung erlaubt ein wesentlich besseres und gezieltes Design solcher Targets mit Hinblick auf die herzustellenden Oxidschichten, besonders bezüglich Spritzerreduktion, Hochtemperaturstabilität und Kristallstruktur.

Weiter können, basierend auf der Erfindung, gezielte Targetzusammensetzungen vorgegeben werden, die in einer markanten Erhöhung des Schmelzpunktes niederschmelzender Materialien zum Ziele der Herstellung hochtemperaturstabiler binärer, ternärer und quaternärer Oxide und Mischoxide höherer Zusammensetzung (quinary, senary etc.) resultieren.

Schliesslich erlaubt die Erfindung ein nahezu vollständiges Schichtdesign der zu synthetisierenden Schichten bezüglich Bildungstemperatur, Kristallstruktur, Phasenzusammensetzung und Freiheit von metallischen Anteilen.

Im Besonderen kann auf der Basis der vorliegenden Erfindung Aluminiumoxid in Korundstruktur hergestellt werden.

Die Erkenntnisse für die Targetherstellung gelten auch für die Verwendung dieser Targets in reaktiven Sputterprozessen, in gepulsten reaktiven Sputterprozessen (sogenanntes High Power Pulsed Sputtering, für das reaktive Modulated Pulsed Sputtering, für das reaktive bipolare Sputtern (Twin Mag Sputtering)) und insbesondere aber für die reaktive kathodische Funkenverdampfung.

Die Erfindung wird anhand einer Zeichnung beispielhaft erläutert. Es zeigen hierbei:
- Figur 1:: Die Oberfläche eines Al-Cr-Legierungstargets;
- Figur 2:: den Querschnitt einer Al-Cr-O/Al-Cr-N Multilagen- schicht;
- Figur 3:: eine Targetoberfläche eines schmelzmetallurgisch her- gestelltes Al-Cr-Target;
- Figur 4:: die Oberfläche des Targets nach Figur 1 vor der Fun- kenverdampfung;
- Figur 5:: die Oberfläche des ungebrauchten Targets B nach Fi- gur 2;
- Figur 6:: ein Phasendiagramm für die binäre Verbindung aus Alu- minium und Chrom;
- Figur 7:: das Target A eine Stunde in einem Sauerstoff mit ei- nem Gasfluss von 300 sccm betrieben;
- Figur 8:: die noch unbenutzte Targetoberfläche Al-V Target;
- Figur 9:: die Oberfläche eines noch unbenutzten Al-V Targets mit anderer Zusammensetzung;
- Figur 10:: eine Targetoberfläche nach einer Stunde Betrieb;
- Figur 11:: ein Al-V Target;
- Figur 12:: das Al-V Phasendiagramm;
- Figur 13a:: eine unbenutzte Targetoberfläche;
- Figur 13b:: die Targetoberfläche nach Figur 13a über eine Stun- de in 1000 sccm Sauerstoff betrieben;
- Figur 14a:: ein Target mit einem Verteilungsmaximum von 63 µm in ungebrauchtem Zustand;
- Figur 14b:: ein Target mit einem Sauerstoffbetrieb über eine Stunde in 1000 sccm.

Die Erfinder haben erkannt, dass bei der Verwendung dieser Targets zur Herstellung von Metalloxiden mittels Funkenverdampfen in der Regel bei Legierungstargets, die durch heiß isostatisches Pressen hergestellt wurden, Probleme auftreten, die auf eine neue, bisher unbekannte Art der "Targetvergiftung" hinweisen, als es jene ist, die im oben genannten Stand der Technik beschrieben ist. Diese Art der "Vergiftung" (Aufoxidation) des Targets äußert sich darin, dass sich während der Funkenverdampfung mit der Zeit und in Abhängigkeit vom Sauerstoffpartialdruck isolierende Inseln auf der Targetoberfläche bilden. Die Inselbildung führt nicht wie das oben erwähnte Einschnüren zum baldigen Abbruch der Funkenentladung, also zu einer deutlichen Destabilisierung der Funkenentladung, wohl aber zu einem unruhigeren und spritzerreichen Funkenbetrieb und einer stark unregelmäßigen Targeterosion, die beide für die Schichtbildung unerwünscht sind.

Vor allem im Zusammenhang mit dem Pulsbetrieb der Funkenentladung, wie er in US 2007/0000772 A1 und WO 2006/099760 A2 beschrieben wird, ist diese Inselbildung unerwünscht. Der Pulsbetrieb beabsichtigt ein ständiges Ändern des örtlichen Funkenverlaufs auf dem Target, um dieses vor dem Aufwachsen dickerer Oxide zu bewahren. Bilden sich aber Inseln auf dem Target, so führt das Pulsen des Funkenstroms auch dazu, dass solche Inseln sich vermehrt vom Target als Spritzer lösen, sobald durch das Pulsen der Weg des Funkens diese Gebiete überstreicht.

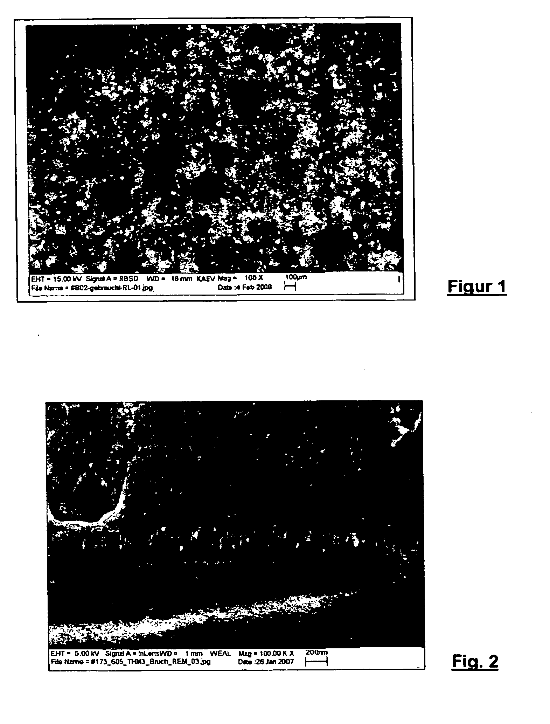

Der Effekt der Oxidinselbildung zeigt sich vor allem an "Legierungstargets", die Materialien sehr unterschiedlicher Schmelztemperaturen umfassen, beispielsweise Al und Cr. In Figur 1 ist die Oberfläche eines Al-Cr-"Legierungstargets" mit einer Zusammensetzung von 70 at% Al und 30 at% Cr dargestellt (im Weiteren bezeichnet mit Target A), das für eine Stunde in reiner Sauerstoffatmosphäre und bei hohem Sauerstoffdruckpartialdruck (2,8 Pa, Sauerstofffluss 1000 sccm) in einer Vakuumanlage zur Werkzeugbeschichtung des Typs Innova der Firma OC Oerlikon Balzers AG betrieben wurde. Die Oberfläche wurde in einem Rasterelektronenmikroskop (REM) aufgenommen unter Benutzung der rückgestreuten Elektronen, die besonders den Materialkontrast hervorheben, so dass man aus den Helligkeitsunterschieden leicht auf die unterschiedlichen Materialien, deren Verteilung und Größe schließen kann. Man kann deutlich mindestens drei Helligkeiten auf dem Target A in Figur 1 unterscheiden. Die hellen Bereiche sind charakteristisch für die Cr-Gebiete, die glatten, dunkleren Bereiche für die Al-Regionen. Für die dunkelsten, erhöht erscheinenden Bereiche wurde eine Materialanalyse mittels energiedispersiver Röntgenanalyse (EDX) vorgenommen, mit der diese Inseln als Aluminiumoxid identifiziert wurden.

Diese Inseln verbleiben unterschiedlich lang auf dem Target und stören den Funkenlauf, weil sie isolierend sind und nicht durchlässig für Gleichstrom und deshalb auch nicht verdampft werden. Wie schon erwähnt, wachsen die isolierenden Inseln an Zahl und Größe mit der Zeit, in der der Funken auf dem Target betrieben wird und wachsen zudem stärker für höheren Sauerstoffpartialdruck während der Funkenverdampfung. Das Inselwachstum stört den freien Funkenlauf auf dem Target und führt zur Verringerung der effektiv verdampfbaren Targetoberfläche.

Mit der Inselbildung wächst aber auch die Gefahr, dass sich diese von der Targetoberfläche lösen und auf diesem einen größeren Krater hinterlassen. Mit der Oxidinselbildung einher geht also eine Art "Entmischung" der Targetoberfläche. Damit ist gemeint, dass einesteils die Oxidinseln auf dem Target als unverdampft verbleiben, wachsen und sich schließlich unkontrolliert vom Target losreißen (aber zu groß sind, um sich in die Schicht einzubauen!), vor allem dann, falls der Betrieb der Quelle durch Pulsen des Kathodenstroms oder Variation des Gasflusses oder der Gasart variiert wird.

Andererseits beobachtet man aber auch, dass die hochschmelzende Komponente des Targets, in diesem Falle Chrom, als metallischer Spritzer verdampft wird und sich in der Schicht abscheiden kann. Figur 2 zeigt den Querschnitt einer Al-Cr-O/Al-Cr-N Multilagenschicht, auf der der Einbau eines solchen metallischen Spritzers in die Schicht zu sehen ist. Die Multilagenstruktur wurde hierbei durch einen ständigen Wechsel des Reaktivgases, also durch einen ständigen Übergang von Sauerstoff in Stickstoff bei ununterbrochener Funkenentladung erzielt. Dieser Wechsel im Reaktivgas führt zu verändertem Funkenverlauf (ganz analog wie beim gepulsten Betrieb des Targets) auf dem Target und somit zur vermehrten Ablösung der Oxidinseln.

Ohne den Vorgang genauer zu verstehen, scheint es einen Zusammenhang der metallischen Spritzerbildung mit dem Oxidinselwachstum (eben eine Art Entmischung) zu geben. Diese "Entmischung" ist sowohl störend für den Funkenbetrieb auf der Kathode, aber auch unerwünscht bei der Schichtabscheidung, weil Spritzer die Schicht mechanisch beeinflussen, unkontrolliert chemisch reagieren bei höheren Temperaturen und deshalb möglicherweise deren Hochtemperaturschichteigenschaften schwächen.

Damit ergaben sich bislang folgende Nachteile, wenn bei der Synthese von Metalloxiden mittels kathodischer Funkenverdampfung pulvermetallurgisch hergestellte Targets verwendet wurden:
1. separates Vorliegen der Ausgangspulver nach dem HIP-Verfahren, d.h. kein einphasiges Target, kein inniges Verbinden der Pulver;
2. Oxidinselbildung auf dem Target, die aus einer der beiden oder einer Mischung der Komponenten des Targets besteht und zum Einbau von metallischen Spritzern in die abgeschiedene Schicht führen kann;
3. Gefahr einer Entmischung an der Targetoberfläche und einer starken Targeterosion durch explosionsartiges Ablösen der Oxidinseln beim Pulsen des Funkenstroms und bei Übergängen zwischen verschiedenen reaktiven Gasen.

Zusammenhängend mit diesen Nachteilen ergeben sich dementsprechend auch Einschränkungen für die Synthese von binären, ternären und quaternären oder Metalloxiden höherer Ordnung:
1. erhöhte Spritzerbildung bei Oxidschichten von pulvermetallurgischen Targets bei der Funkenverdampfung, besonders falls die Schmelzpunkte der metallischen Komponenten sehr unterschiedlich sind;
2. Beschränkung auf ein gewisses Prozessfenster betreffs des Sauerstoffflusses mit der Gefahr einer gewissen Unterstöchimetrie der synthetisierten Schichten bezüglich Sauerstoff;
3. ungenügende Kontrolle über die Schichtqualität (Härte, Morphologie, Struktur) durch unkontrolliertes Inselwachstum am Target und dementsprechend unkontrolliertem Einbau von metallischen Spritzern in die Schicht.

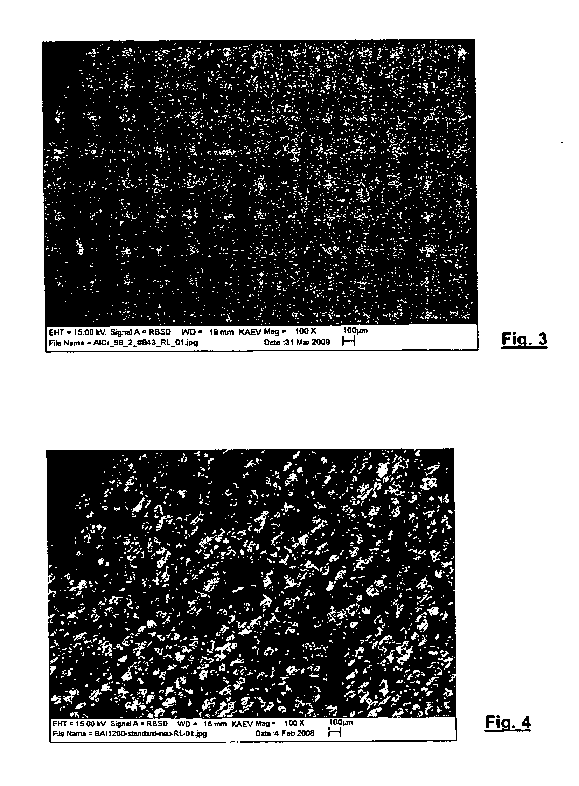

In Figur 3 ist eine Targetoberfläche gezeigt, die ebenfalls eine Stunde lang unter gleichem Sauerstofffluss (1000 sccm) und mit gleichem Funkenstrom betrieben wurde wie das Target A in Figur 1. Bei diesem Target handelte es sich ebenfalls um ein Al-Cr-Target, das aber im Gegensatz zum Target A nicht pulvermetallurgisch, sondern schmelzmetallurgisch hergestellt wurde. Zudem besitzt dieses Target eine Zusammensetzung von Al (98 at%)/Cr (2 at%) (im Weiteren bezeichnet mit Target B). Im Unterschied zum Target A zeigen sich beim Target B keine Oxidinselbildungen.

Targets für die Oxidherstellung, die aus einer einzigen kristallinen Phase bestehen sind in CH 00688863 beschrieben. Allerdings wird dort nicht auf eine Oxidinselbildung eingegangen, wohl aber überhaupt auf die Möglichkeit, ein solches einphasiges Target in einer Atmosphäre, die Sauerstoff enthält, betreiben zu können.

Basierend auf diesem Stand der Technik und den eigenen Beobachtungen wurde nun erfindungsgemäß herausgefunden, dass die Herstellungsmethode der Targets einen Einfluss auf die Oxidinselbildung haben kann. Diese Erkenntnis wird erhärtet, falls man die Oberflächen der Targets vor der Funkenverdampfung in REM Aufnahmen vergleicht. In Figur 4 ist die Oberfläche des Targets A vor der Funkenverdampfung, also ungebraucht, gezeigt. Man sieht deutlich in der REM-Aufnahme die Einbettung der helleren Bereiche des Cr in die dunklere Al-Matrix.

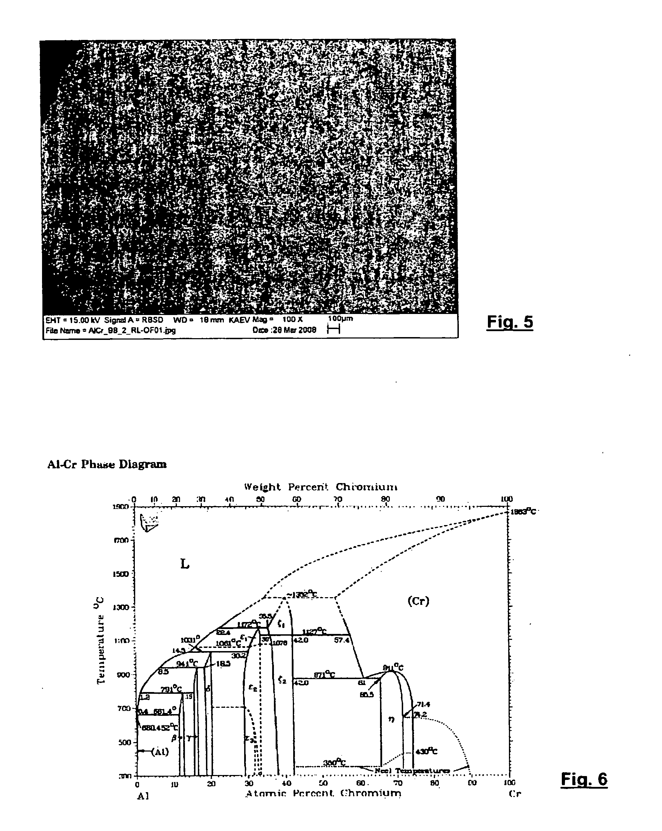

Zum Vergleich ist die Oberfläche des ungebrauchten Targets B in Figur 5 dargestellt. Im Gegensatz zu Target A sieht man kaum getrennte Bereiche der Ausgangsmaterialien Al und Cr, was auch nicht verwunderlich ist, weil eine schmelzmetallurgische Herstellung zu einer einheitlichen Phase bzw. zu einem Mischkristall der Ausgangsmaterialien führt.

Während man beim HIP-Verfahren frei ist in der Mischbarkeit der Pulver, ist die schmelzmetallurgische Herstellung von Legierungstargets nur in bestimmten Zusammensetzungen möglich. Diese Mischungsverhältnisse lassen sich grob aus den dem Fachmann bekannten Phasendiagrammen der binären metallischen Verbindungen (für Targets bestehend aus zwei metallischen Komponenten) abschätzen.

In Figur 6 ist ein solches Phasendiagramm für die binäre Verbindung aus Al und Cr angegeben. Demzufolge müsste das schmelzmetallurgische Target mit 2 at% Cr in Al bei ca. 800°C hergestellt worden sein. Der Schmelzpunkt von Al liegt bei etwa 660°C, d.h. dass Al über den Schmelzpunkt aufgeheizt werden muss, um die geforderte Cr-Konzentration im Target zu erzielen. Daraufhin muss dann möglichst schnell abgekühlt werden, damit diese Konzentration "eingefroren" wird und es zu keiner Entmischung der Materialien wegen der verschiedenen Dampfdrücke kommt. Dies wird um so kritischer, je höher die Fertigungstemperatur der Targets über der Schmelztemperatur der niederschmelzenden Komponente liegt.

Wollte man nun das Target A auf schmelzmetallurgische Weise herstellen, so müsste man für 30 at% Cr-Anteil ein Al-Cr-Gemisch auf über 1200°C aufheizen, dessen Zusammensetzung konstant halten (was schwierig ist, da Al bei dieser Temperatur schon einen hohen Dampfdruck hat) und dann möglichst schnell abkühlen, um die Zusammensetzung "festzufrieren". Nach der Erfindung ist es also viel einfacher ein Pulvergemisch zusammenzumischen und dieses im HIP Verfahren zu bearbeiten, als den komplizierten schmelzmetallurgischen Herstellungsprozess für dieselben Targets zu kontrollieren.

Im Rahmen der Erfindung wurde erkannt, dass sich bei der Verwendung von schmelzmetallurgisch hergestellten Targets bei der Synthese von Metalloxiden mittels kathodischer Funkenverdampfung folgende Nachteile ergeben:
1. keine freie Wahl in der Zusammensetzung ("Verbote" auf der Basis der Phasendiagramme!);
2. aufwendiger und teurer Herstellungsprozess;
3. Anpassung des Herstellungsprozesses an die jeweilige Targetzusammensetzung (Temperatur, Abkühlzeit, Berücksichtigung der verschiedenen Dampfdrucke);
4. keine Synthese binärer hochschmelzender Oxide über die einphasigen binären Legierungen möglich (also die Herstellung von Al₂O₃ in Korundstruktur aus einem einphasigen binären Target).

Es besteht daher ein Bedürfnis nach Targets, die die im Vergleich zum schmelzmetallurgisch hergestellten Target freiere Mischbarkeit und einfache Herstellungstechnologie der pulvermetallurgischen Targets mit dem "einphasigen" Verhalten bei der Oxidation und der Vermeidung der Oxidinselbildung der schmelzmetallurgisch hergestellten Targets kombinieren.

Mit der Erfindung wird eine Zusammensetzungsanweisung für Targets angegeben, basierend auf den Phasendiagrammen für binäre Legierungen für die pulvermetallurgischen Legierungstargets, um bestimmte Bildungstemperaturen der Oxide und deren Phasengemische festzulegen.

Die Erfindung hat zum Ziel, die Oxidinselbildung zur vermeiden sowie die Reduktion der Spritzer bei der Herstellung von Oxidschichten mittels kathodischer Funkenverdampfung. Es wurden während der Entwicklung eine Vielzahl verschiedener Targets untersucht, die sowohl unterschiedliche Zusammensetzungen bezüglich der Materialien, bezüglich deren Konzentration und bezüglich der Pulverkorngröße aufwiesen.

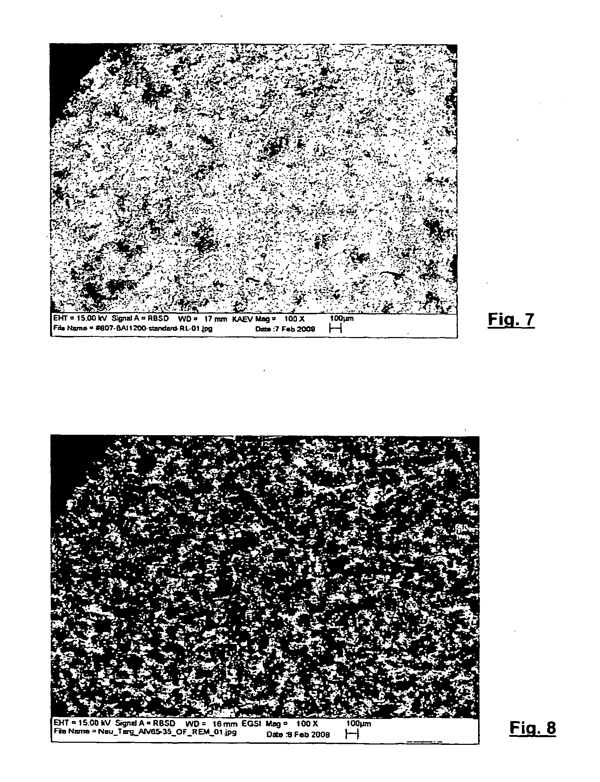

Zuerst wurde ein Prozessfenster festgelegt, in dem besonders gut die Oxidinselbildung untersucht werden konnte. Um das zu erläutern, soll wieder das Target A betrachtet werden. In Figur 7 wurde das Target A auch eine Stunde lang in reinem Sauerstoff betrieben, aber nur mit einem Gasfluss von 300 sccm. Die resultierende Oberfläche im Vergleich zum Betrieb in reinem Sauerstofffluss von 1000 sccm (Figur 1) weist wesentlich weniger Oxidinselbildung auf als das bei höherem Sauerstofffluss der Fall ist.

Gleiche Versuche wurden auch mit anderen Targetzusammensetzungen des gleichen Materialsystems gemacht, beispielsweise mit Al (50 at%)/Cr (50 at%), Al (85 at%)/Cr (15 at%) und Al (25 at%)/Cr (75 at%). Die Oxidinselbildung war für alle diese Targets bei diesem Gasfluss nur gering oder nicht sichtbar. Der Sauerstoffgehalt in den bei diesen Versuchen synthetisierten Oxidschichten wurde mittels Rutherford Backscattering Spectroscopy (RBS) ermittelt und lag innerhalb (Al,Cr)₂O_{2,80} bis (Al,Cr)₂O_{2,95}, womit man im Rahmen der Messgenauigkeit dieser Methode auf stöchimetrische Schichten schließen kann. Allerdings war der Gehalt, immer auf der Sauerstoffdefizitseite. Dieses Resultat kann mit den metallischen Spritzern in der Schicht erklärt werden, welche (Vergleiche Figur 2) nicht durchoxidiert sind. Für die Stöchiometrie bei den Schichten, die mit 1000 sccm abgeschieden wurden, ergaben sich ähnliche Ergebnisse.

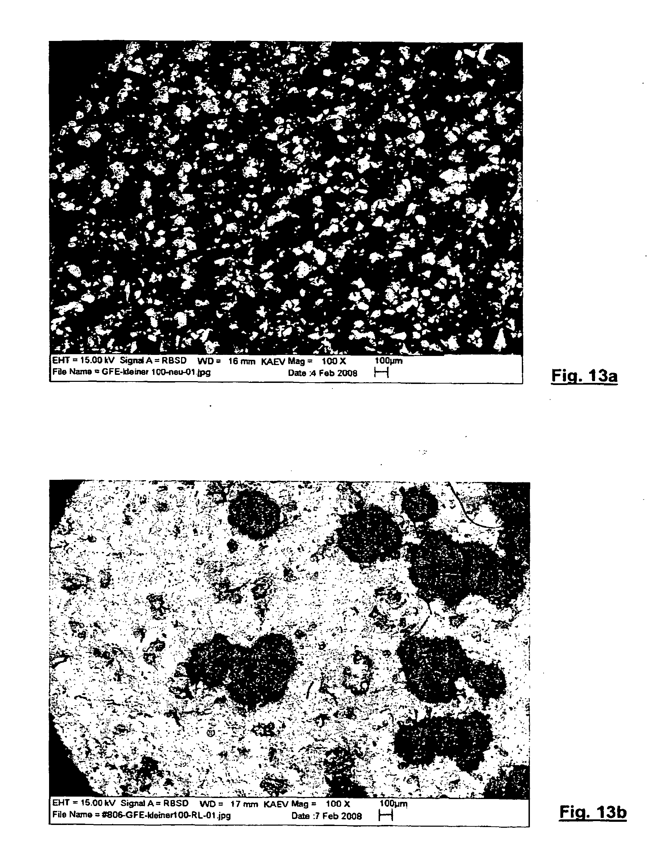

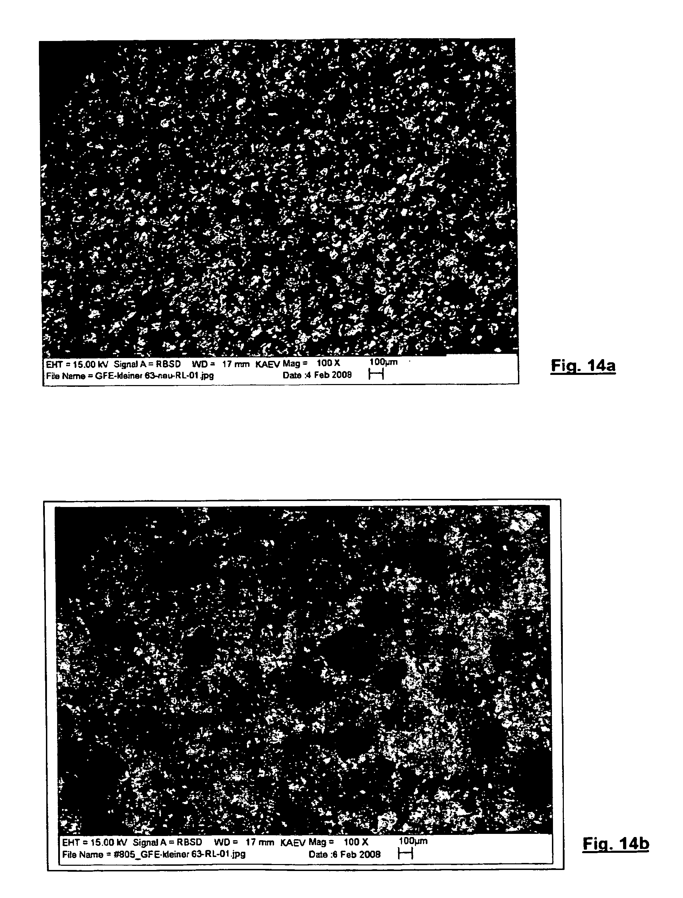

Weiter wurden auch pulvermetallurgische Targets aus unterschiedlichen Korngrößen hergestellt und untersucht. In Figur 13 ist die ungenutzte (a) und die wie in Figur 1 über eine Stunde in 1000 sccm Sauerstoff betriebene Targetoberfläche (b) dargestellt. Der Hersteller der Targets gibt für die Korngrößen ein Verteilungsmaximum von ca. 100 µm an. In den Figuren 14(a) und 14(b) wurden Targets mit einem Verteilungsmaximum von 63 µm untersucht. In beiden Fällen zeigt sich der Effekt des Oxidinselwachstums deutlich. Diese Erfahrung wurde für Targets mit Korngrößenbereichen der Pulver zwischen 10 µm und 300 µm gemacht.

Auch für andere Materialien musste das Fenster für die Oxidinselbildung festgelegt werden. Dabei wurden Materialsysteme wie TiAl, AlV AlNb, AlHf, AlZr, AlZrY, AlTa, sowie für eine Reihe anderer Targetmischungen bestehend aus der III. und IV. Hauptgruppe und der 4., 5. und 6. Nebengruppe untersucht und es wurden in den meisten Fällen beim Betrieb mit 300 sccm keine oder nur Ansätze von Oxidinseln gefunden, bei 1000 sccm entweder starkes Inselwachstum oder, was überraschend war, kein Inselwachstum.

Dieses überraschende Ergebnis, dass Inselwachstum vermieden werden kann, auch wenn mit großen Sauerstoffflüssen gearbeitet wird, ermöglichte erfindungsgemäß nicht nur eine Methode zum gezielten Targetdesign für Metalloxide, sondern aufbauend auf diesen Erkenntnissen auch eine bisher unbekannte Methode für die gezielte Synthese oxidischer Schichten.

In Experimenten wurde zuerst in Fällen, bei denen auch bei 1000 sccm kein Inselwachstum auftrat, der Sauerstofffluss bis an die Grenze des vom Pumpsystem möglichen Sauerstoffflusses von 1600 sccm (entsprechend einem Druck von ca. 5 Pa) erhöht. Aber auch unter diesen Bedingungen konnte für diese Targets kein Oxidinselwachstum erzielt werden, was durchaus unerwartet war. Schließlich wurde für alle Materialien der Sauerstofffluss von 1000 sccm beim Betrieb eines Targets benutzt.

Anstoß zu einem möglichen Verständnis gab wie schon oben erwähnt das Verhalten des schmelzmetallurgischen Targets, auf dem sich auch bei 1000 sccm keine Oxidinseln bildeten. Die weitgehende Einphasigkeit des Targets war eine mögliche Erklärung für die Vermeidung von binären Oxidinselausscheidungen, also der Oxidbildung der niederschmelzenden metallischen Targetkomponente. Basierend auf dem Al-Cr-Phasendiagramm in Figur 6, müsste die Temperatur etwa 800°C sein, um 2 at% Cr in 98 at% Al zu lösen. Dann sollte ein schnelles Abkühlen des Al-Cr-Gemischs erfolgen, um diese 2 at% Cr in die 98 at% Al "einzufrieren", da beim Abkühlen im thermischen Gleichgewicht ein solch hoher Cr-Gehalt nicht erreicht werden kann.

Phasendiagramme in T. B. Massalski, Hugh Baker, L.H. Bennett, and Joanne L. Murray, Binary Alloy Phase Diagrams, American Society for Metals, ISBN 0-87170-261-4 beschreiben die Phasen und Phasenumwandlungen, die im thermodynamischen Gleichgewicht vor sich gehen und können also nicht oder nur sehr bedingt zur Beschreibung einer solch schnellen Abkühlung verwendet werden.

Wenn man sich die noch unbenutzte Oberfläche eines pulvermetallurgisch hergestellten Targets anschaut (Figur 4 für Target A), sieht man deutlich, dass man es nicht mit einem einphasigen Material zu tun hat, sondern dass die Pulver immer noch sehr gut getrennt voneinander vorliegen.

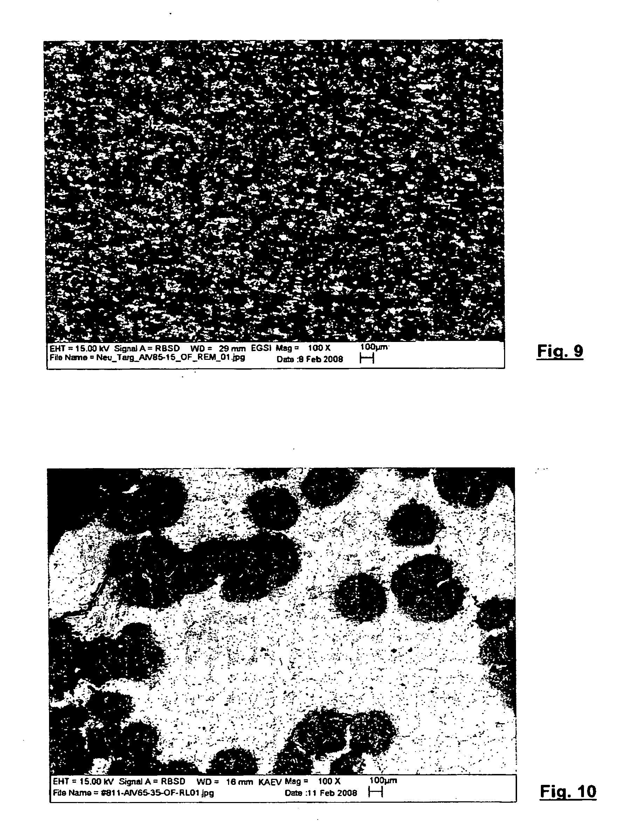

Dies trifft nicht nur auf das Al-Cr-System zu. In Figur 8 sind die noch unbenutzte Targetoberfläche eines Al (65 at%)-V (35 at%)-Targets und in Abbildung 9 die Oberfläche eines noch unbenutzten Al (85 at%)-V (15 at%)-Targets abgebildet. In beiden Fällen kann man auch hier deutlich die beiden Materialien Al und V am Helligkeitsunterschied erkennen. Natürlich wurde deshalb auch erwartet, dass es in beiden Fällen zu einem Oxidinselwachstum auf der Targetoberfläche kommen würde, wenn man diese Targets in 1000 sccm Sauerstoff betreiben würde.

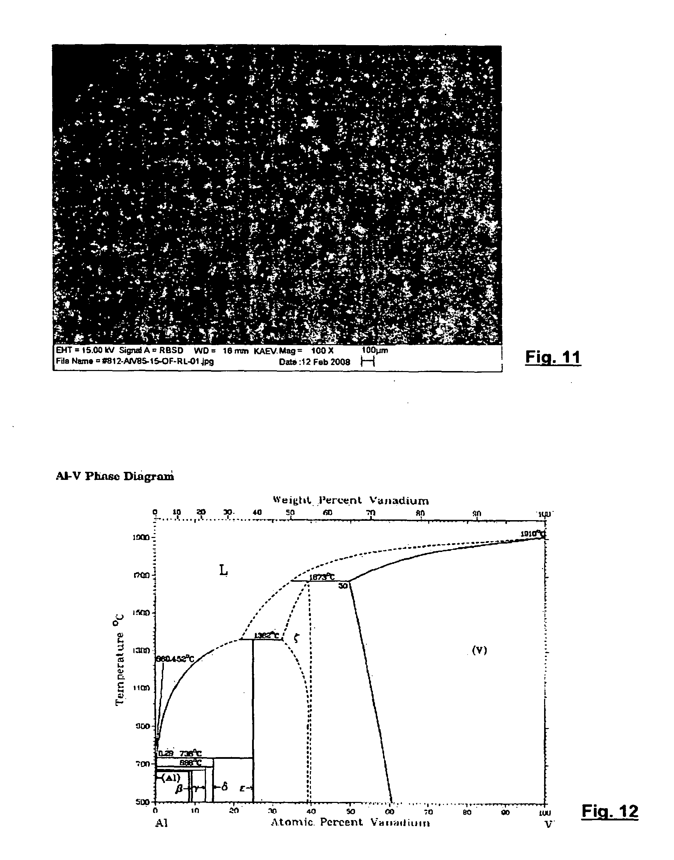

Umso erstaunlicher war es, dass lediglich auf dem Al (65 at%)-V (35 at%)-Target Oxidinselwachstum beobachtet wurde, wie in Figur 10 dargestellt. Auf der Oberfläche des in Abbildung 11 dargestellten Al (85 at%)-V (15 at%)-Targets konnten keine Oxidinseln festgestellt werden. '

Um dieses überraschende Ergebnis zu verifizieren, wurden nun eine Reihe weiterer pulvermetallurgischer Targets untersucht, wobei unterschiedliche Materialien und deren Zusammensetzungen variiert wurden. Schließlich wurde auch noch die Korngröße der Ausgangspulver geändert, um die Natur der Oxidinselbildung zu verstehen.

Obwohl die Funkenverdampfung weit entfernt von Gleichgewichtsprozessen verläuft, wurde anhand der Phasendiagramme eine mögliche Erklärung gefunden.

Das Al-Cr-Materialsystem sollte hierzu anhand des Phasendiagramms in der üblichen Weise betrachtet werden, d. h. aus der Schmelze kommend, also von hohen Temperaturen her. Bei 30 at% Cr-Anteil kommt man bei ca. 1300°C in einen Bereich der Koexistenz zwischen Flüssigkeit und fester Phase, bestehend aus der ξ1-Phase und dem Mischkristall. Zu tiefen Temperaturen durchquert man die Gebiete der festen ε1, ε2 und ε3 Phasen.

Angenommen, das Phasendiagramm würde auch in etwa sehr schnelle Ungleichgewichtsprozesse (die quasi adiabatisch ablaufen) bezüglich der Temperatur beschreiben, würde man beim schnellen Verdampfen diese Phasen alle durchqueren müssen, ehe man das Material aufschmelzen und mit nutzbaren Raten verdampfen würde.

Das Durchqueren der Bereiche unterschiedlicher fester Phasen kann zu einer wie auch immer gearteten Entmischung der metallischen Komponenten führen und beispielsweise zu einer Ausscheidung des Aluminium, bevorzugt an den Korngrenzen, und zur schnellen Oxidation des Al kommen, noch ehe die Phase bzw. das Phasengemisch in ihrer Gesamtheit die Schmelztemperatur erreicht hätte.

Die gleiche Argumentation trifft für eine Zusammensetzung von Al (50 at%)/Cr (50 at%) oder beispielsweise auch für eine Targetzusammensetzung von Al (27 at%)/Cr (73 at%) zu. Auch hier beobachtet man Oxidinselwachstum. Allerdings nicht so ausgeprägt, vermutlich weil die Ausscheidung von metallischem Cr, die natürlich auch bei den Phasenübergängen vorkommen kann, im Allgemeinen für den Funkenbetrieb des Targets und dessen Vergiften weniger kritisch ist, da die Oxidbildung mit Chrom bei viel höheren Temperaturen stattfindet.

Erfindungsgemäss wird daher nach Konzentrationen der metallischen Komponenten für das Target eingestellt, bei denen, ausgehend von unterhalb der Schmelztemperatur der niedrigschmelzenden metallischen Komponente, mit ansteigender Temperatur lediglich ein einziger Übergang von der festen Phase zu einer Phase mit flüssigem Bestandteil stattfindet.

Solche Konzentrationen sind insbesondere dann zu finden, wenn die Löslichkeit der festen Bestandteile über weite Temperaturbereiche im Wesentlichen temperaturunabhängig ist.

Beispiele für Bereiche, die kein nachweisbares Inselwachstum sogar nach 5 h Betrieb der Targets in 1000 sccm Sauerstoff aufwiesen hatten Cr-Targetanteile von 15 at%, und 18 at%, also jene Bereiche im Phasendiagramm, bei denen eine Änderung der Phasenmischung erst in dem Bereich der Koexistenz zwischen fester und flüssiger Phase stattfindet. Dabei war es dann gleichgültig, ob noch ein zusätzlicher Übergang von einer fest-flüssigen Koexistenzphase in eine weitere fest-flüssige Koexistenzphase überquert werden muss, um in die komplettflüssige Phase zu gelangen.

Stichproben für andere Gebiete des Phasendiagramms ergaben unter den oben geschilderten Prozessbedingungen leicht nachweisbares Inselwachstum aus Aluminiumoxid oder Chromoxid.

Der Bereich für Cr-Anteile über 75 at% ist ebenfalls frei von Inselwachstum, da in diesem Bereich die Al-Löslichkeit in Cr parallel zur Temperaturachse über den gesamten Weg in die Flüssigphase konstant bleibt. Die Erkenntnis, dass dies aber auch in anderen Bereichen funktioniert, solange nur sichergestellt ist, dass ausgehend von unterhalb der Schmelztemperatur der niedrigschmelzenden metallischen Komponente, mit ansteigender Temperatur lediglich ein einziger Übergang von der festen Phase zu einer Phase mit flüssigem Bestandteil stattfindet, ist ein weitere Aspekt der vorliegenden Erfindung.

Wie beispielsweise das Phasendiagramm eines Al-Nb-Systems zeigt, sind solche gut nutzbaren Bereiche bei einer Nb-Konzentration im Wesentlichen > 0.5 at% bis 60 at% und von ca. 93 at% bis im Wesentlichen < 99.5 at%. Die reinen Metalle (Nb 0 at% (entspricht Al 100 at%) und Nb 100 at% sind dabei ausgeschlossen, weil erfindungsgemäß mindestens zwei metallische Bestandteile zur Verfügung stehen müssen, um den Schmelzpunkt zu beeinflussen.

Bei dem Al-V-Materialsystem (siehe Phasendiagramm Figur 12) wurde nun diese Hypothese auch nachgeprüft. Für 35 at% V-Anteil muss man durch ein Phasengemisch aus der ε Phase und ξ Phase, weiter durch die ξ Phase, um dann erst in den einen Bereich der Koexistenz von fest und flüssig, bestehend aus Mischkristall und ξ Phase, zu gelangen. Das heißt, dass man durch Bereiche verschiedener fester Phasen muss, ehe man in den Koexistenzbereich von Flüssigkeit und fester Phase kommt und es dementsprechend zu Ausscheidungen kommt, die Oxidinseln bilden.

Bei 15 at% V-Anteil liegen die Dinge anders. Dort gelangt man aus einem existierenden δ- und ε-Phasengemisch direkt in eine Koexistenz zwischen flüssiger und fester Phase, die aus Mischkristall und ε Phase besteht. Für dieses Target konnte auch kein Oxidinselwachstum beobachtet werden.

Daher sollte der Übergang beim Aufheizen nicht über Phasengrenzen rein fester Phasen stattfinden, falls man die Oxidinselbildung vermeiden möchte und auch den Einbau der metallischen Spritzer in die Schicht verringern möchte.

Die Untersuchungen wurden für eine Vielzahl von erfindungsgemäß präparierten Targets wiederholt und es kam nie zur Oxidinselbildung.

Beispielsweise wurde diese Vermutung an dem Al-Nb-Materialsystemen, z.B. an Al (80 at%)/Nb (20 at%) überprüft und konnte bestätigt werden.

Ebenso wenig kam es bei:
Ti (20 at%)/Al (80 at%)-Targets,
Al (86 at%)/Zr (14 at%)-Targets,
Al (80 at%)/Hf (15 at%)-Targets,
Al (80 at%)/Zr (20 at%)-Targets,
Al (60 at%)/B (40 at%)-Targets zu einer sichtbaren Oxidinselbildung.

Das Betreiben der Funkenentladung in reiner Sauerstoffatmosphäre kann die Bereiche der Koexistenz zwischen fester und flüssiger Phase bezüglich der Temperatur verändern und schmale Temperaturbereiche für Phasenbildung in der Nähe des Schmelzpunktes des niederschmelzenden Metalls möglicherweise überbrücken.

Basierend auf der empirischen Erklärung für den Mechanismus der Oxidinselbildung auf dem Target kann noch ein anderer Mechanismus bei der Funkenverdampfung, der die Bildung der zu synthetisierenden Oxidschicht (nicht der Inseln auf dem Target!) betrifft, erklärt werden.

Es ist die Bildung binärer Metalloxide von einem pulvermetallurgischem Target mit zwei metallischen Komponenten. Man kann über die Zusammensetzung des Targets, sobald man keine wesentlichen Entmischungen durch die Phasenübergänge hat, die Schmelztemperatur und damit die Bildungstemperatur des entsprechenden Oxides festlegen. Das geht aus den vorhergehend beschriebenen Untersuchungen hervor, die illustrieren, dass die Phasendiagramme zur Erklärung des kathodischen Funkens herangezogen werden können. Mit anderen Worten: die Funkenverdampfung pulvermetallurgischer Targets erlaubt die Einstellung der Stöchiometrie des zu synthetisierenden Metalloxides und der entsprechenden Phase oder des entsprechenden Phasengemisches. Selbstverständlich sind diese Oxide vom thermodynamischen Standpunkt aus i.a. nicht stabil bei Normaltemperatur, aber sie sind stabil bei Temperaturen ihrer Bildungstemperatur und meist auch darüber.

Als Beispiel soll wieder auf das Al-Cr-Materialsystem eingegangen werden. Mit einer Konzentration von Al (70 at%)/ Cr (30 at%) erwartet man anhand des Phasendiagramms einen Übergang in die Schmelze mit entsprechend erhöhter Oxidationsfreudigkeit und Verdampfungsfreudigkeit bei etwa 1300°C. Falls dieses Oxid bei dieser Temperatur oder darüber gebildet wird, sollte es anhand des Phasendiagramms für das ternäre Al-Cr-0 [9] eine Korundstruktur besitzen. Das ist der Fall, wie anhand von Röntgenmessungen nachgewiesen wurde und was auch in der WO 2008/009619 A1 beschrieben wird. Andere Phasen des aufgeschmolzenen Materials wären nur möglich, falls es zu einer spürbaren Entmischung an der Targetoberfläche käme, was dann auch einen geänderten Schmelzpunkt zur Folge hätte und was sich in der Schichtstöchiometrie widerspiegeln sollte. Andere Phasen (ausgenommen die metallischen Spitzer!) konnten weder mittels Röntgenbeugung und auch nicht mit der wesentlich sensitiveren Methode der Elektronenbeugung im Durchstrahlungsmikroskop gefunden werden.

Es gibt nun aber auch im Al-Cr-Phasendiagramm Bereiche, bei denen der Übergang in die flüssige Phase unter der Bildungstemperatur des ternären Mischkristalloxids liegt. Dann sollte sich ein Phasengemisch aus den binären Oxiden bilden.

Um diese Hypothese zu prüfen, wurden Schichten mit einem Target der Konzentration Al (85 at%)/Cr (15 at%) hergestellt. Anhand des Phasendiagramms hat man dann folgende Situation. Man ist im Bereich entweder der ß- und γ-Phase oder der γ-Phase allein und dann im Bereich der δ-Phase in Koexistenz mit der flüssigen Phase. Der vollständige Übergang in die flüssige Phase mit der vollständigen Oxidation würde dann bei ca. 1000°C erfolgen. Vom Phasendiagramm des ternären Al-Cr-O [9] weiß man nun, dass bei dieser Temperatur die binären Oxide noch phasengetrennt vorliegen. Das sich bildende Al₂O₃ bei ca. 1000°C sollte die Korundstruktur aufweisen. Man muss hier anfügen, dass die Kristallitgröße bei diesen Schichten klein ist und dass man deswegen keine Beugungsreflexe in den Röntgenspektren sieht. Mit Elektronenbeugung konnte jedoch die Korundstruktur des Aluminiumoxids nachgewiesen werden. Dieses Resultat konnte auch für ein Al (80 at%)-Cr (20 at%)-Target bestätigt werden, wobei in diesem Falle die Korundstruktur des Al₂O₃ noch ausgeprägter vorlag. In beiden Fällen wurden auch keine Oxidinseln auf der Targetoberfläche gebildet, wie es ja auch nach den obigen Erklärungen zu erwarten war. Bei einem elementaren Aluminiumtarget konnte verständlicherweise keine Korundstruktur erhalten werden, da der Übergang in die flüssige Phase schon bei ca. 660°C erfolgte, also zu tief lag, um die Korundgitterstruktur zu bilden.

Diese Erhöhung des Schmelzpunktes des Al zum Zwecke der Bildung der Korundstruktur des Al₂O₃ kann ganz analog auch in anderen Materialsystemen erfolgen. Beispielsweise mit einem pulvermetallurgischem Al-Target, das ca. 4 at% Nb enthält oder mit einem pulvermetallurgischem Al-Target, das ca. 4 at% V enthält oder 2 at% Zr oder 8 at% Hf, wie leicht aus den binären Phasendiagrammen der metallischen Komponenten herausgelesen werden kann. Ob sich dann jeweils das binäre Oxid bildet oder ob es zur Bildung des ternären Oxids oder Mischoxids kommt, hängt von den Phasengleichgewichtsdiagrammen (binäres der Metalle verglichen mit ternärem der Metalloxide) ab, was auch wieder ganz analog dem Beispiel für das Al-Cr-0 nachvollzogen werden kann.

Falls diese Phasengleichgewichtsdiagramme noch nicht gemessen wurden, kann immer noch der experimentelle Weg über die Variation der Targetkomposition gegangen werden, um gezielte Strukturen zu erreichen.

Zusammenfassend kann man sagen, dass bei der Funkenverdampfung zur Synthetisierung von Oxiden sich über die Targetzusammensetzung der metallischen Komponenten eine in etwa dem Phasen-' diagramm entsprechende Bildungstemperatur des oder der möglichen Oxide so einstellen lässt, dass auch Hochtemperaturphasen binärer Oxide hergestellt werden können. Nicht verhindert werden kann für einige Konzentrationsverhältnisse aber (falls der Übergang durch mehrere feste Phasen in die Phase der Koexistenz von Flüssig-Fest erfolgt) die Oxidinselbildung auf den Targets. In dieser Beschreibung wurde offenbart, wie anhand des Phasendiagramms entschieden werden kann, wo dies nicht stattfindet, d.h. wie entsprechende Targets aufgebaut sein sollten, um das Problem der Oxidinselbildung zu vermeiden.

Da sowohl für die Synthetisierung ternärer Oxide wie auch die gezielte Synthetisierung binärer hochtemperaturstabiler Oxide die freie Wahl in der Targetzusammensetzung ohne die Gefahr einer Oxidinselbildung auf dem Target wünschenswert ist, soll nun noch eine Methode angegeben werden, die dies in den meisten Fällen für den gesamten Zusammensetzungsbereich der pulvermetallurgischen Targets gestattet.

Als Beispiel wird wieder das binäre Al-Cr-Phasendiagramm benutzt, um das prinzipielle Vorgehen zu erläutern, obwohl es gerade für dieses Anwendungsbeispiel gewisse Limitierungen aufweist.

Die Lösung beruht zum einen auf der Erkenntnis, dass bei der Funkenverdampfung, obwohl beim pulvermetallurgischen Target die Körner der metallischen Komponenten noch deutlich getrennt voneinander vorliegen, in etwa der Schmelzpunkt des Komponentengemisches nach binärem Phasendiagramm erreicht wird, damit das Oxid gebildet wird. Zum anderen beruht sie darauf, dass beim Übergang einer einzelnen Phase in die Schmelze keine Oxidinseln formiert werden (siehe schmelzmetallurgisches Target).

Möchte man nun ein Target herstellen, das erlaubt eine Al-Cr-O-Schicht mit je 50 at% der metallischen Komponenten herzustellen, wird erfindungsgemäß dieses Target aus Pulvern der möglichen und noch problemlos herzustellenden Mischkristallpulver zusammengemischt, also beispielsweise aus Al mit 2 at% Cr (schmelzmetallurgisches Pulver) und Cr mit 10 at% Al (schmelzmetallurgisches Pulver) oder anderen möglichen Zusammensetzungen in entsprechendem Verhältnis, die man für praktisch jedes binäre System finden kann.

Eine weitere Methode solche Targets herzustellen beruht auf der Methode des Plasmaspritzens, bei der auch in gewissen Bereichen die Pulver frei mischbar sind und trotzdem hohe Temperaturen erzielt werden können, um die metallischen Elemente zu mischen und schnell abzuscheiden.

Erfindungsgemäß wurde somit herausgefunden, dass die Funkenverdampfung "ziemlich adiabatisch" abläuft und man sich deshalb grob an den Phasendiagrammen orientieren kann. Die Schichten werden in dem Substrattemperaturbereich, in dem wir gewöhnlich arbeiten, am Target vorformiert bzw. gebildet. Die Substrattemperatur beeinflusst im Wesentlichen nur die Kristallitgröße.

Die Erkenntnisse gelten nicht nur für Al-basierende Schichten und sie gelten nur für binäre Oxide. Wie der Fachmann erkennt, ist durch die oben beschriebenen Methoden ein schönes Werkzeug offenbart, um auch für ganz andere Anwendungen als den Werkzeug- oder Komponentenbereich Schichtdesign betreiben zu können (Ferroelectrica, Supraleiter, Katalysatoren, Barrieren, ...)

Insbesondere ist die Erfindung für die folgenden Anwendungen verwendbar:
1. Werkzeuge:
   - Wendeschneidplatten auf der Basis von Hartmetall, Cermet, Bornitrid, Siliziumnitrid oder Siliziumkarbid zum Fräsen, Drehen oder Bohren
   - Fräser wie Kugelkopf- oder Schaftfräser
   - Gewindefräser
   - Abwälzfräser
   - Bohrer
   - Gewindebohrer
   - Reibaalen
   - Gravurwerkzeuge
2. Umform- und Stanzwerkzeuge:
   - Formen für Aluminiumdruckguss
   - Formen für Kunststoffspritzen
   - Extrusionswerkzeuge
   - Werkzeuge zur Blechumformung
   - Stempel zum stanzen von Metallen
   - Schmiedebacken, insbesondere zum Warmschmieden
   - Werkzeuge zum Warmbördeln
3. Komponenten und Bauteile im Kraftfahrzeug- und speziell im Motorenbereich:
   - Ventile
   - Tastenstössel
   - Düsennadel
   - Kipphebel
   - Nockenstössel
   - Rollenbolzen
   - Schlepphebel
   - Nockenstössel
   - Nockenwelle
   - Nockenwellenlager
   - Ventilstössel
   - Kipphebel
   - Kolbenringe
   - Kolbenbolzen
   - Injektor und Injektorteile
   - Turbinenschaufeln
   - Pumpenteile
   - Hochdruckpumpe
   - Getriebe
   - Zahnräder
   - Anlaufscheiben
   - Komponenten von elektrische Steuerungs- und Beschleunigungssystem
   - Komponente im ABS System
   - Lager
   - Kugellager
   - Rollenlager
   - Nockenwellenlager

## Patentansprüche

1. Verfahren zur Herstellung oxidischer Schichten mittels PVD (pysical vapor deposition), insbesondere mittels kathodischer Funkenverdampfung, wobei ein pulvermetallurgisches Target verdampft wird, **dadurch gekennzeichnet, dass** zur Abscheidung einer oxidischen Schicht mit einer Zusammensetzung, die außerhalb einer Zusammensetzung liegt, bei der die metallischen oder halbmetallischen Bestandteile beim Aufheizen im Übergang von Raumtemperatur in die Flüssigphase bezogen auf das Phasendiagramm keine Phasengrenze rein fester Phasen überschreiten, das pulvermetallurgische Target aus zumindest zwei Komponenten ausgebildet wird, wobei eine erste Komponente eine erste Zusammensetzung der metallischen und halbmetallischen Bestandteile besitzt, bei der beim Aufheizen im Übergang von Raumtemperatur in die Flüssigphase bei dieser ersten Zusammensetzung keine Phasengrenzen rein fester Phasen bezogen auf das Phasendiagramm überschritten werden und die zumindest zweite Komponente metallisch oder halbmetallisch ist oder eine andere Zusammensetzung der metallischen und halbmetallischen Bestandteile besitzt, bei der beim Aufheizen im Übergang von Raumtemperatur in die Flüssigphase bei dieser zweiten Zusammensetzung keine Phasengrenzen rein fester Phasen bezogen auf das Phasendiagramm überschritten werden, und die erste Komponente und die zweite Komponente und ggf. weitere Komponenten und/oder die Ausgangsmetalle oder -halbmetalle so gemischt werden, dass die gewünschte Zusammensetzung der Metalloxidschicht erzielt wird, wobei die oxidische Schicht einen Anteil von mehr als 70 at% Aluminiumoxid in Korundstruktur aufweist unter Verwendung mindestens eines pulvermetallurgisch hergestellten Targets bestehend aus Aluminium und zumindest einem weiteren metallischen oder halbmetallischen Bestandteil, wobei dessen Zusammensetzung einen Übergang in die Flüssigphase zwischen 1000°C und 1200°C aufweist.

2. Verfahren nach Anspruch 1, **dadurch gekennzeichnet, dass** pulvermetallurgische Targets mit Korngrößen kleiner 300 µm, bevorzugt kleiner 200 µm, weiter bevorzugt kleiner 100 µm, aus mindestens 2 metallischen oder halbmetallischen Bestandteilen verwendet werden.

3. Verfahren nach einem der vorhergehenden Ansprüche, **dadurch gekennzeichnet, dass** zur Herstellung hochtemperaturstabiler ternärer oder höherer Oxide mittels PVD unter Verwendung eines Legierungstargets aus mindestens 2 metallischen oder halbmetallischen Bestandteilen die Zusammensetzung der Legierung so gewählt wird, dass nach Phasendiagramm mit dem Übergang in die flüssige Phase die Bildungstemperatur im wesentlichen festgelegt wird.

4. Verfahren nach einem der vorhergehenden Ansprüche, **dadurch gekennzeichnet, dass** zum Herstellen von pulvermetallurgischen Targets zur Herstellung von Oxidschichten unter Vermeidung von Spritzern Ausgangspulver aus Phasengemischen verwendet werden, die jedes für sich Zusammensetzungen aufweisen, für die beim Aufheizen im Übergang von Raumtemperatur in die Flüssigphase keine Phasengrenzen rein fester Phasen überschritten werden.

5. Pulvermetallurgisches Target zur Herstellung oxidischer Schichten mittels PVD (pysical vapor deposition), insbesondere mittels kathodischer Funkenverdampfung, wobei ein pulvermetallurgisches Target verdampft wird und das pulvermetallurgische Target aus zumindest zwei Bestandteilen besteht, die metallisch und/oder halbmetallisch sind, **dadurch gekennzeichnet, dass** zur Abscheidung einer oxidischen Schicht mit einer Zusammensetzung, die außerhalb einer Zusammensetzung liegt, bei der die metallischen und/oder halbmetallischen Bestandteile beim Aufheizen im Übergang von Raumtemperatur in die Flüssigphase keine Phasengrenze rein fester Phasen überschreiten, das Target aus zumindest zwei Komponenten ausgebildet wird, wobei eine erste pulvermetallurgische Komponente eine erste Zusammensetzung der metallischen und/oder halbmetallischen Bestandteile besitzt, bei der beim Aufheizen im Übergang von Raumtemperatur in die Flüssigphase bei dieser ersten Zusammensetzung keine Phasengrenzen rein fester Phasen überschritten werden und die zumindest zweite Komponente metallisch oder halbmetallisch ist oder eine andere Zusammensetzung der metallischen und halbmetallischen Bestandteile als die erste Komponente besitzt, bei der beim Aufheizen im Übergang von Raumtemperatur in die Flüssigphase bei dieser zweiten Zusammensetzung keine Phasengrenzen rein fester Phasen überschritten werden, und die erste Komponente und die zweite Komponente und ggf. weitere Komponenten und/oder die reinen Metalle oder Halbmetalle so gemischt sind, dass die gewünschte Zusammensetzung der Metalloxidschicht erzielt wird, wobei das Target aus Aluminium und zumindest einem weiteren metallischen oder halbmetallischen Bestandteil besteht, wobei dessen Zusammensetzung einen Übergang in die Flüssigphase zwischen 1000°C und 1200°C aufweist.

6. Target nach Anspruch 5, **dadurch gekennzeichnet, dass** die das pulvermetallurgisch hergestellte Target ausbildenden Komponenten und/oder Bestandteile und/oder Metalle oder Halbmetalle eine Korngröße kleiner 300 µm, vorzugsweise kleiner 200 µm und weiter bevorzugt kleiner 100 µm besitzen.

7. Target nach einem der Ansprüche 5 oder 6, **dadurch gekennzeichnet, dass** sich die Bestandteile im Schmelzpunkt um mindestens 100°C bis 500°C unterscheiden.

8. Target nach einem der Ansprüche 5 bis 7, **dadurch gekennzeichnet, dass** zumindest eines der Ausgangspulver aus zwei Phasen oder Mischkristallen gemischt ist oder aus einer oder mehreren Phasen und einem oder mehreren Mischkristallen.

## Claims

1. Method for producing oxide layers by means of PVD (physical vapour deposition), in particular by means of cathodic arc vaporisation, wherein a powder-metallurgical target is vaporised, **characterised in that**, for deposition of an oxide layer with a composition that lies outside a composition in which the metallic or semi-metallic constituents, in relation to the phase diagram, do not cross any phase boundary of purely solid phases during the transition from room temperature to the liquid phase during heating, the powder-metallurgical target is formed of at least two components, a first component having a first composition of the metallic or semi-metallic constituents, in which, during a transition from the room temperature into the liquid phase during heating, no phase boundaries of purely solid phases, in relation to the phase diagram, is crossed in this first composition, and the at least second component being metallic or semi-metallic or having a different composition of the metallic or semi-metallic constituents, in which, during a transition from the room temperature into the liquid phase during heating, no phase boundaries of purely solid phases, in relation to the phase diagram, are crossed in this second composition, the first component and the second component, and optionally further components, and/or the starting metals or starting semi-metals being mixed in such a way that the desired composition of the metal oxide layer is obtained, the oxide layer having a content of more than 70 at% aluminium oxide in a corundum structure, using at least one powder-metallurgically produced target consisting of aluminium and at least one further metallic or semi-metallic constituent, the composition thereof exhibiting a transition into the liquid phase between 1000°C and 1200°C.

2. Method according to claim 1, **characterised in that** powder-metallurgical targets are used with grain sizes of less than 300 µm, preferably of less than 200 µm, still more preferably of less than 100 µm, made of at least two metallic or semi-metallic constituents.

3. Method according to any one of the preceding claims, **characterised in that** for the production of high-temperature stable ternary or higher oxides by means of PVD by using an alloy target of at least two metallic or semi-metallic constituents, the composition of the alloy is selected in such a way that, according to the phase diagram, the formation temperature is substantially determined with the transition into the liquid phase.

4. Method according to any one of the preceding claims, **characterised in that**, for the production of the powder-metallurgical targets for producing oxide layers while avoiding splatters, starting powders of phase mixtures are used, each of which as such having compositions for which, in the transition from room temperature into the liquid phase during heating, no phase boundaries of purely solid phases are crossed.

5. Powder-metallurgical target for producing oxide layers by means of PVD (physical vapour deposition), in particular by means of cathodic arc vaporisation, wherein a powder-metallurgical target is vaporised and the powder-metallurgical target consists of at least two constituents that are metallic and/or semi-metallic, **characterised in that**, for deposition of an oxide layer with a composition outside of a composition in which the metallic and/or semi-metallic constituents do not cross any phase boundary of purely solid phases during the transition from room temperature to the liquid phase during heating, the target is formed of at least two components, a first powder-metallurgical component having a first composition of the metallic and/or semi-metallic constituents, in which, during a transition from the room temperature into the liquid phase during heating, no phase boundaries of purely solid phases are crossed in this first composition, and the at least second component being metallic or semi-metallic or having a composition of the metallic or semi-metallic constituents which is different from the first composition and in which, during a transition from the room temperature into the liquid phase during heating, no phase boundaries of purely solid phases are crossed in this second composition, and the first component and the second component, and optionally further components, and/or the pure metals or semi-metals being mixed in such a way that the desired composition of the metal oxide layer is obtained, the target consisting of aluminium and at least one further metallic or semi-metallic constituent, the composition thereof exhibiting a transition into the liquid phase between 1000°C and 1200°C.

6. Target according to claim 5, **characterised in that** the components and/or constituents and/or metals or semi-metals forming the powder-metallurgically produced target have a grain size of less than 300 µm, preferably less than 200 µm, and still more preferably, of less than 100 µm.

7. Target according to any one of the claims 5 or 6, **characterised in that** the constituents differ with regard to the melting point by at least 100°C to 500°C.

8. Target according to any one of the claims 5 to 7, **characterised in that** at least one of the starting powders is mixed from two phases or mixed crystals or from one or more phases and one or more mixed crystals.

## Revendications

1. Procédé pour la réalisation de couches d'oxydes au moyen du procédé PVD (déposition physique en phase vapeur), en particulier au moyen d'une vaporisation par arc cathodique, dans lequel on vaporise une cible réalisée en métallurgie des poudres, **caractérisé en ce que**, pour déposer une couche d'oxyde avec une composition qui se trouve à l'extérieur d'une composition dans laquelle les éléments constitutifs métalliques ou semi-métalliques, lors du chauffage à la transition de la température ambiante vers la phase liquide et par référence au diagramme de phase, on ne dépasse aucune limite de phase de pure phase solide, la cible réalisée en métallurgie des poudres est réalisée à partir d'au moins deux composants, dans lesquels un premier composant possède une première composition des éléments constitutifs métalliques et semi-métalliques qui, lors du chauffage à la transition de la température ambiante vers la phase liquide pour cette première composition, ne dépasse aucune limite de phase de pure phase solide par référence au diagramme de phase et ledit au moins un second composant est métallique ou semi-métallique ou possède une autre composition des éléments constitutifs métalliques et semi-métalliques pour laquelle, lors du chauffage à la transition de la température ambiante vers la phase liquide pour cette seconde composition on ne dépasse aucune limite de phase de phase purement solide par référence au diagramme de phase, et le premier composant et le second composant et le cas échéant d'autres composants et/ou les métaux de départ ou semi-métaux de départ sont mélangés de telle façon que la composition souhaitée de la couche d'oxyde métallique est obtenue, ladite couche d'oxyde présentant une part de plus de 70 atomes % d'oxyde aluminium dans une structure de type corindon en utilisant au moins une cible produite par métallurgie des poudres, constituée d'aluminium et d'au moins un autre élément constitutif métallique ou semi-métallique, dont la composition présente une transition vers la phase liquide entre 1000° C et 1200° C.

2. Procédé selon la revendication 1, **caractérisé en ce que** l'on utilise des cibles réalisées en métallurgie des poudres avec des tailles de particules inférieures à 300 µm de préférence inférieures à 200 µm, de façon encore plus préférée inférieures à 100 µm, à partir d'au moins deux éléments constitutifs métalliques ou semi-métalliques.

3. Procédé selon l'une des revendications précédentes, **caractérisé en ce que** pour la production d'oxydes ternaires ou supérieurs stables à haute température au moyen du procédé PVD en utilisant une cible d'alliage d'au moins deux éléments constitutifs métalliques ou semi-métalliques, la composition de l'alliage est choisie de telle façon que d'après le diagramme de phase avec la transition vers la phase liquide la température de formation est sensiblement fixée.

4. Procédé selon l'une des revendications précédentes, **caractérisé en ce que** pour produire des cibles en métallurgie des poudres pour la réalisation de couches d'oxydes en évitant des projections, on utilise une poudre de départ formée de mélanges de phase qui présentent chacun pour soi des compositions pour lesquelles on ne dépasse aucune limite de phase de phase purement solide lors du chauffage à la transition de la température ambiante vers la phase liquide.

5. Cible réalisée en métallurgie des poudres pour la production de couches au d'oxyde au moyen du procédé PVD (déposition physique en phase vapeur), en particulier au moyen d'une vaporisation par arc cathodique, dans laquelle on vaporise une cible réalisée en métallurgie des poudres et la cible réalisée en métallurgie des poudres est constituée d'au moins deux éléments constitutifs qui sont métalliques et/ou semi-métalliques, **caractérisée en ce que**, pour déposer une couche d'oxyde avec une composition qui se trouve à l'extérieur d'une composition pour laquelle les éléments constitutifs métalliques et/ou semi-métalliques, lors du chauffage à la transition de la température ambiante vers la phase liquide, ne dépassent aucune limite de phase de phase purement solide, la cible est réalisée en au moins deux composants, dans lesquels un premier composant réalisé en métallurgie des poudres possède une première composition des éléments constitutifs métalliques et/ou semi-métalliques, pour laquelle, lors du chauffage à la transition de la température ambiante vers la phase liquide pour cette première composition, on ne dépasse aucune limite de phase de phase purement solide, et ledit au moins un second composant est métallique ou semi-métallique ou possède une autre composition des éléments constitutifs métalliques et semi-métalliques que le premier composant, pour laquelle lors du chauffage à la transition de la température ambiante vers la phase liquide pour cette seconde composition, on ne dépasse aucune limite de phase de phase purement solide, et le premier composant et le second composant et le cas échéant d'autres composants et/ou les métaux ou semi-métaux purs sont mélangés de telle façon que l'on obtient la composition souhaitée de la couche d'oxyde métallique, la cible étant constituée d'aluminium et d'au moins un autre élément constitutif métallique ou semi-métallique, ladite composition présentant une transition vers la phase liquide entre 1000° C et 1200° C.

6. Cible selon la revendication 5, **caractérisée en ce que** les composants qui forment la cible réalisée en métallurgie des poudres et/ou les éléments constitutifs et/ou les métaux ou semi-métaux possèdent une taille de particules inférieure à 300 µm, de préférence inférieure à 200 µm et de façon encore plus préférée inférieure à 100 µm.

7. Cible selon l'une des revendications 5 ou 6, **caractérisée en ce que** les éléments constitutifs présentent des températures de fusion qui diffèrent d'au moins 100° C à 500° C.

8. Cible selon l'une des revendications 5 à 7, **caractérisée en ce que** l'une au moins des poudres de départ est mélangée à partir de deux phases ou cristaux mixtes, au à partir d'une ou plusieurs phases et d'un ou plusieurs cristaux mixtes.
